# EUROPEAN PATENT APPLICATION

(11) **EP 4 489 547 A1**
(43) Date of publication of application: **08.01.2025**
(21) Application number: 22928137.3
(22) Date of filing: 27.07.2022
(51) Int. Cl.: H10K 59/00

(54) **DISPLAY PANEL AND DISPLAY APPARATUS**

(30) Priority: 28.02.2022 CN 202210193420
(71) Applicant: Kunshan Go-Visionox Opto-Electronics Co., Ltd., KunShan, Jiangsu 215300 (CN)
(72) Inventor: LOU, Junhui, Suzhou City, Jiangsu 215300 (CN); WU, Yong, Suzhou City, Jiangsu 215300 (CN); GE, Lin, Suzhou City, Jiangsu 215300 (CN); HE, Zeshang, Suzhou City, Jiangsu 215300 (CN)
(74) Representative: Kraus & Lederer PartGmbB
(86) International application number: PCT/CN2022/108255
(87) International publication number: WO 2023/159868

(57) **Abstract**

The present application discloses a display panel and a display apparatus, and the display panel includes sub-pixels, pixel driving circuits, and connection lines. The sub-pixels include first sub-pixels located in the first display area and second sub-pixels located in the second display area. The pixel driving circuits include first circuits and second circuits located in the second display area. The first circuits are configured to drive the first sub-pixels located in the first display area and located in the second display area, so that the light transmittance of the first display area can be increased, which is beneficial for under-screen integration of a photosensitive component. The connection lines include first connection lines, at least a part of the first connection line extends along a first direction and is located at a side of the first circuit, so that the arrangement of the first connection line is simplified, the first connection line is located in the space reserved between the first circuits, and the interaction between the first connection line and the first circuit can be reduced.

## Description

### CROSS REFERENCE TO RELATED APPLICATION

The present application claims priority to Chinese Patent Application No. 202210193420.0 filed on February 28, 2022, and titled "DISPLAY PANEL AND DISPLAY APPARATUS", which is incorporated herein by reference in its entirety.

### TECHNICAL FIELD

The present application relates to the field of display, and particularly to a display panel and a display apparatus.

### BACKGROUND

With the rapid development of electronic devices, demands of users for the screen-to-body ratio are higher and higher, resulting in that the full-screen display of electronic devices attracts more and more attention in the industry.

In order to achieve under-screen integration for a photosensitive component or to achieve a narrow frame, pixel circuits for driving sub-pixels in a frame display area or a light-transmitting display area are arranged in other areas, which causes non-uniform display of a display panel.

### SUMMARY

Embodiments of the present application provide a display panel and a display apparatus, aiming to improve the display effect of the display panel.

Embodiment of a first aspect of the present application provide a display panel including a first display area and a second display area, and the display panel includes: sub-pixels including first sub-pixels located in the first display area and second sub-pixels located in the second display area; pixel driving circuits located in the second display area and including first circuits configured to drive the first sub-pixels and second circuits configured to drive the second sub-pixels; and connection lines including first connection lines for connecting the first circuits with the first sub-pixels; in which at least a part of the first connection line extends along a first direction and is located at a side of the first circuit.

Embodiments of a second aspect of the present application provide a display apparatus including the display panel according to any of the embodiments of the first aspect.

The display panel according to the embodiments of the first aspect of the present application includes the sub-pixels, the pixel driving circuits, and the connection lines. The sub-pixels include the first sub-pixels located in the first display area and the second sub-pixels located in the second display area, the first sub-pixels are used for achieving the display of the first display area, and the second sub-pixels are used for achieving the display of the second display area. The pixel driving circuits include the first circuits and the second circuits located in the second display area. The first circuits are configured to drive the first sub-pixels located in the first display area, and thus the pixel driving circuits for driving the sub-pixels in the first display area are located in the second display area. If the first display area is a frame display area, other driving circuits can be arranged in the first display area, so that a narrow frame can be achieved for the display panel. If the first display area is a light-transmitting display area, a light transmittance of the first display area can be increased, so that a photosensitive component can acquire light information through the first display area, which is beneficial for under-screen integration of the photosensitive component. The connection lines include the first connection lines for connecting the first circuits with the first sub-pixels, and at least a part of the first connection line extends along a first direction and is located at a side of the first circuit, so that the first connection lines are located in the reserved space of the first circuits, and at least a part of the first connection line does not overlap the first circuit. Accordingly, the interaction between the first connection line and the first circuit can be reduced, and the display effect of the display panel can be improved.

### BRIEF DESCRIPTION OF THE DRAWINGS

Other features, objects and advantages of the present application will become more apparent from reading the following detailed description of the non-limiting embodiments with reference to the accompanying drawings, in which the same or similar reference numerals represent the same or similar features, and the accompanying drawings are not drawn to actual scale.
Fig. 1 shows a schematic structural diagram of a display panel according to embodiments of a first aspect of the present application;
Fig. 2 shows a partial enlarged view of an arrangement structure of sub-pixels in area Q of the display panel in Fig. 1;
Fig. 3 shows a partial enlarged view of a part of pixel driving circuits in area Q of the display panel in Fig. 1;
Fig. 4 shows a cross-sectional view at B-B in Fig. 2;
Fig. 5 shows a partial enlarged schematic structural diagram of Fig. 3;
Fig. 6 shows a cross-sectional view at B-B in Fig. 2 in another embodiment;
Fig. 7 shows a partial enlarged view of a part of pixel driving circuits in area Q of the display panel in Fig. 1 in another embodiment;
Fig. 8 shows a partial enlarged view of an arrangement structure of sub pixels in area Q of the display panel in Fig. 1 in another embodiment;
Fig. 9 shows a schematic structural diagram of a display apparatus according to embodiments of a second aspect of the present application;
Fig. 10 shows a cross-sectional view at C-C in Fig. 9.

### DETAILED DESCRIPTION

Features and exemplary embodiments of various aspects of the present application will be described in detail below. In order to make the objects, technical solutions and advantages of the present application clearer, the present application is further described in detail below with reference to the accompanying drawings and specific embodiments. It should be understood that the specific embodiments described herein are only used to explain the present application, but not to limit the present application. For those skilled in the art, the present application can be implemented without some of these specific details. The following description of the embodiments is only to provide a better understanding of the present application by illustrating examples of the present application.

In an electronic device such as a mobile phone and a tablet computer, photosensitive components such as a front camera, an infrared light sensor, and a proximity light sensor need to be integrated at a side of the display panel. In some embodiments, a light-transmitting display area may be arranged on the electronic device and the photosensitive components may be arranged at the back of the light-transmitting display area, so that a full-screen display can be achieved for the electronic device while ensuring that the photosensitive components operate normally.

In order to increase the light transmittance of the light-transmitting display area, the driving circuits for the light-transmitting area are usually arranged in a non-light-transmitting area. In the prior art, the connection line between the driving circuit and the sub-pixel is usually above the driving circuit layer, which causes parasitic capacitance between the driving circuit and the connection line, and the parasitic capacitance may affect the signal transmission in the connection line or the driving circuit.

In some other related embodiments, in order to achieve a narrow frame for a display apparatus, a width of an encapsulation area and a size of a circuit need to be reduced, therefore, the reliability and anti-drop capability of the encapsulation, and the driving capacity of the circuit are adversely affected. In some related arts, shift registers are arranged in a frame display area of the display panel, and pixel circuits for driving sub-pixels in the frame display area are arranged in other areas, which causes non-uniform display of the display panel.

In order to solve the problems described above, the embodiments of the present application provide a display panel and a display apparatus, which will be described below with reference to the accompanying drawings.

The embodiments of the present application provide a display panel, which may be an organic light emitting diode (OLED) display panel.

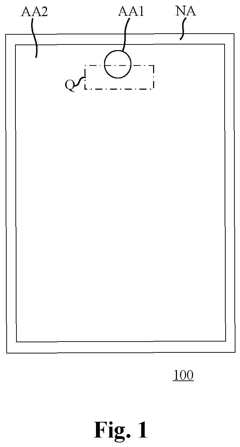

Fig. 1 shows a schematic top view of a display panel according to embodiments of a first aspect of the present application.

As shown in Fig. 1, the display panel 100 includes a first display area AA1, a second display area AA2, and a non-display area NA surrounding the first display area AA1 and the second display area AA2. Optionally, a light transmittance of the first display area AA1 is greater than a light transmittance of the second display area AA2. Optionally, the second display area AA2 is arranged around at least a part of the first display area AA1. In some other embodiments, the first display area AA1 may be arranged around at least a part of the second display area AA2.

Herein, if the second display area AA2 is arranged around at least a part of the first display area AA1 and the first display area AA1 is a light-transmitting display area, it is preferred that the light transmittance of the first display area AA1 is greater than or equal to 15%. In order to ensure that the light transmittance of the first display region AA1 is greater than 15%, or greater than 40%, or even a higher light transmittance, the light transmittances of a part of functional film layers of the display panel 100 in the embodiment are all greater than 80%, or even the light transmittances of at least a part of the functional film layers are greater than 90%.

In the display panel 100 according to the embodiments of the present application, the light transmittance of the first display area AA1 is greater than the light transmittance of the second display area AA2, so that the photosensitive components can be integrated at the back of the first display area AA1 of the display panel 100 to achieve under-screen integration for the photosensitive components such as cameras, while the first display area AA1 can display images, the display area of the display panel 100 is increased, and a full-screen design is achieved for the display apparatus.

If the first display area AA1 is the light-transmitting display area, the number of the first display area AA1 and the number of the second display area AA2 may be set in a variety of ways, for example, the number of the first display area AA1 is one and the number of the second display area AA2 is one, so as to achieve the under-screen integration for the photosensitive components or fingerprint recognition. Alternatively, in some other optional embodiments, the number of the first display areas AA1 is two, in which one of the first display areas AA1 is used for the under-screen integration of the photosensitive components and the other one of the first display areas AA1 is used for the fingerprint recognition.

Optionally, if the first display area AA1 is arranged around at least a part of the second display area AA2, that is, the first display area AA1 is a frame display area, driving components such as shift registers can be arranged in the first display area AA1, so that the size of the frame of the display panel 100 can be reduced, and the narrow frame can be achieved.

Optionally, the first display area AA1 may include both of the light-transmitting display area and the frame display area, so that both of the under-screen integration of the photosensitive components and the narrow frame can be achieved.

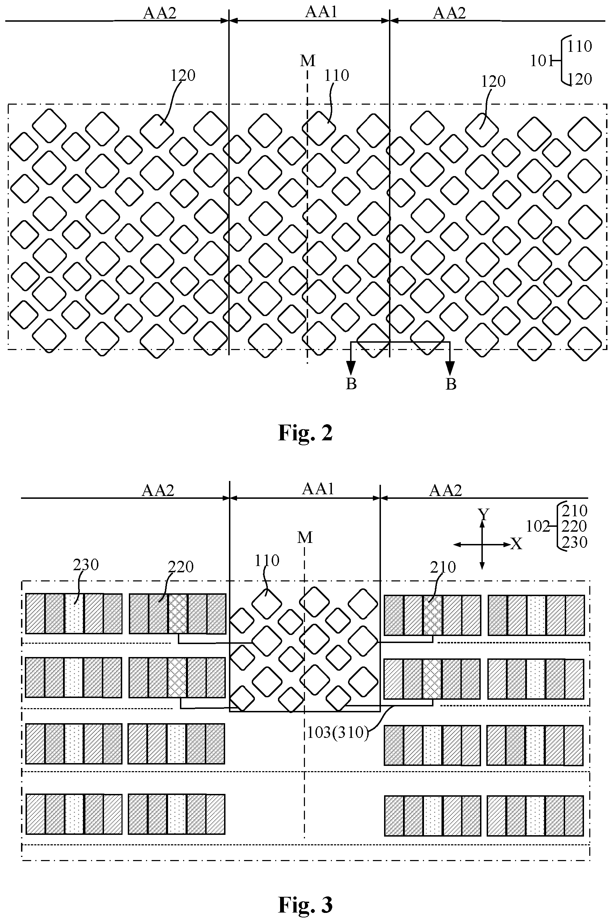

Reference is made to Fig. 1 to Fig. 3 together, in which Fig. 2 shows a partial enlarged schematic view of an arrangement structure of sub-pixels 101 in area Q of Fig. 1, and Fig. 3 shows a partial enlarged schematic view of a part of pixel driving circuits in area Q in Fig. 1.

As shown in Fig. 1 to Fig. 3, the display panel 100 according to the embodiments of the present application includes sub-pixels 101, pixel driving circuits 102, and connection lines 103. The sub-pixels 101 include first sub-pixels 110 located in the first display area AA1 and second sub-pixels 120 located in the second display area AA2; the pixel driving circuits 102 are located in the second display area AA2 and include first circuits 210 configured to drive the first sub-pixels 110 and second circuits 220 configured to drive the second sub-pixels 120; and the connection lines 103 include first connection lines 310 for connecting the first circuits 210 with the first sub-pixels 110. At least a part of the first connection line 310 extends along a first direction X and is located at a side of the first circuit 210 along a second direction Y

The first display area AA1 may be the light-transmitting display area or the frame display area, and in the embodiments of the present application, for example, the first display area AA1 is the light-transmitting display area, that is, the second display area AA2 surrounds at least a part of the first display area AA1.

In order to better illustrate the connection relationship between the first circuits 210 and the first sub-pixels 110, the first sub-pixels 110 in the first display area A1 are shown in Fig. 3, and only a part of the pixel driving circuits 102 of the area Q is shown in Fig. 3.

The display panel 100 according to the embodiments of the first aspect of the present application includes the sub-pixels 101, the pixel driving circuits 102, and the connection lines 103. The sub-pixels 101 include the first sub-pixels 110 located in the first display area AA1 and the second sub-pixels 120 located in the second display area AA2, the first sub-pixels 110 are used for achieving the display of the first display area AA1, and the second sub-pixels 120 are used for achieving the display of the second display area AA2. The pixel driving circuits 102 include the first circuits 210 and the second circuits 220 located in the second display area AA2. The first circuits 210 are configured to drive the first sub-pixels 110 located in the first display area AA1 to emit light, and thus the pixel driving circuits 102 for driving the sub-pixels 101 in the first display area AA1 are located in the second display area AA2, and the light transmittance of the first display area can be increased, so that the photosensitive component 200 can acquire light information through the first display area AA1, which is beneficial for the under-screen integration of the photosensitive component.

The connection lines 103 include the first connection lines 310 for connecting the first circuits 210 with the first sub-pixels 110, the first connection line 310 extends along the first direction X, and at least a part of the first connection line 310 is located at a side of the first circuit 210 along the second direction Y. On the one hand, the first connection line 310 is located in the reserved space between the first circuits 210, and on the other hand, an overlapping area between the first connection line 310 and the first circuit 210 can be reduced, so as to reduce the interaction between the first connection line 310 and the first circuit 210. Accordingly, in the embodiments of the present application, the under-screen integration can be achieved for the photosensitive component, and also the interaction between the first connection line 310 and the first circuit 210 can be reduced.

In addition, in the display panel 100 according to the embodiments of the present application, the first circuits 210 are compressed along the second direction Y. Accordingly, on the one hand, the space occupied by the first circuits 210 can be reduced, and on the other hand, sufficient space can be reserved for arranging the first connection lines 310, and the overlapping area between the first connection line 310 and the first circuit 210 can be reduced.

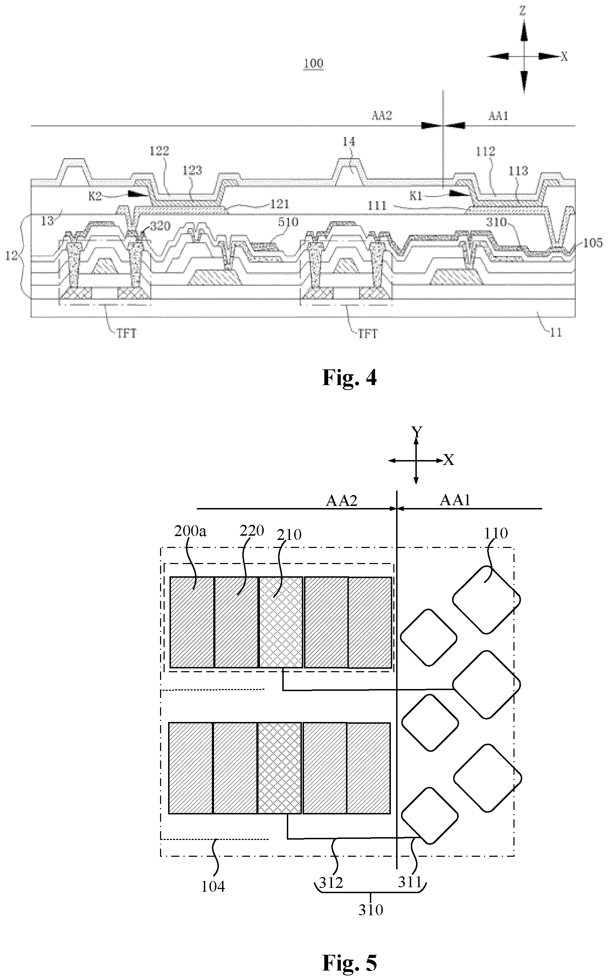

Reference is made to Fig. 4, which shows a cross-sectional view at B-B in Fig. 2.

In some optional embodiments, the display panel 100 further includes a first signal line layer 105 including a first signal line 510, at least a part of the first connection line 310 is located in the first signal line layer 105, and the first signal line 510 includes at least one of a data line, a scanning line, a power line, a voltage reference line, and a ground line.

Optionally, the first signal line 510 may be manufactured by a photolithography manufacturing process. When the first signal line 510 is manufactured by the photolithography process, steps such as film forming, coating, exposure, developing, etching and peeling need to be performed in sequence, and exposure needs to be performed on a photoresist layer using a mask plate in the exposure step.

In these optional embodiments, at least a part of the first connection line 310 is located in the first signal line layer 105, and the first signal line 510 includes at least one of the data line, the scanning line, the power line, the voltage reference line, and the ground line, so that at least the part of the first connection line 310 can be manufactured simultaneously with at least one of the data line, the scanning line, the power line, the voltage reference line and the ground line, no additional process for manufacturing the first connection line 310 is added, and the number and processing of the mask plates are not increased. Accordingly, the manufacturing process of the display panel 100 can be simplified, and the manufacturing efficiency of the display panel 100 can be improved.

Still referring to Fig. 3 and Fig. 4, the display panel 100 may further include a substrate 11, an array base plate layer 12 arranged on the substrate, and a pixel definition layer 13. The pixel driving circuits 102 may be arranged in the array base plate layer 12. The first circuit 210 and the second circuit 220 may each include a thin film transistor (TFT). The array base plate layer 12 may further include structures such as a capacitor. The pixel definition layer 13 includes pixel openings including first pixel openings K1 located in the first display area AA1 and second pixel openings K2 located in the second display area AA2. The first sub-pixel 110 includes a first electrode 111, a second electrode 112, and a first light-emitting structure 113 located between the first electrode 111 and the second electrode 112, and the first light-emitting structure 113 is located in the first pixel opening K1. The first electrode 111 is connected with the TFT of the first circuit 210 through the first connection line 310. The second sub-pixel 120 includes a third electrode 121, a fourth electrode 122, and a second light-emitting structure 123 located between the third electrode 121 and the fourth electrode 122, and the second light-emitting structure 123 is located in the second pixel opening K2. Support pillars 14 may be further arranged on the pixel definition layer 13. The first electrode 111 and the third electrode 121 may be pixel electrodes, and the second electrode 112 and the fourth electrode 122 may be interconnected as a whole-surface electrode.

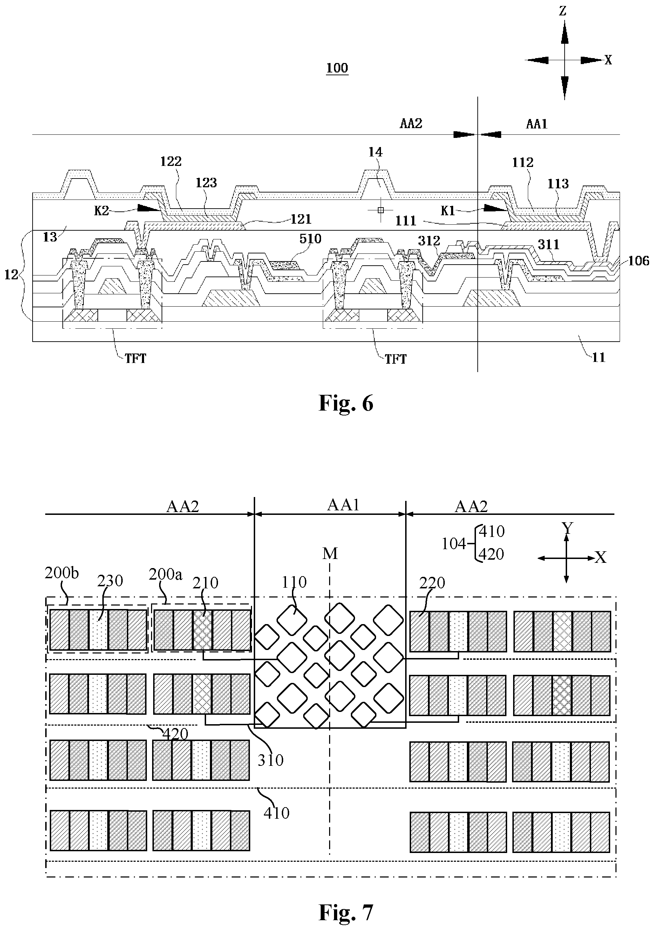

Reference is made to Fig. 4 to Fig. 6 together, in which Fig. 5 shows a partial enlarged schematic structural diagram of Fig. 3, and Fig. 6 shows a partial enlarged schematic structural diagram at B-B in Fig. 2 in another embodiment.

In some optional embodiments, the display panel 100 further includes a light-transmitting signal line layer 106, the first connection line 310 includes a first segment 311 located in the first display area AA1 and a second segment 312 located in the second display area AA2, the first segment 311 is located in the light-transmitting signal line layer 106, and the second segment 312 is located in the first signal line layer 105 and/or the light-transmitting signal line layer 106.

In these optional embodiments, the first segment 311 of the first connection line 310 is located in the light-transmitting signal line layer 106, so that the light transmittance of the first display area AA1 can be further increased. If the second segment 312 is located in the first signal line layer 105 in the second display area AA2, the second segment 312 and the first signal line 510 may be manufactured simultaneously. If the second segment 311 is located in the light-transmitting signal line layer 106 in the first display area AA1, the second segment 312 and the light-transmitting signal line layer 106 may be manufactured simultaneously, no additional process for manufacturing the first connection line 310 is added, and the number and processing of the mask plates are not increased. In addition, if the first segment 311 and the second segment 312 are both located in the light-transmitting signal line layer 106, the first segment 311 and the second segment 312 do not need to be connected through a via, so that the shape of the first connection line 310 can be simplified, and the signal transmission stability on the first connection line 310 can be improved.

Optionally, as shown in Fig. 4, the connection lines 103 further include second connection lines 320 for connecting the second circuits 220 with the second sub-pixels 120.

Reference is made to Fig. 7, which shows a partial enlarged schematic structural diagram of the area Q of in Fig. 1 in another embodiment.

As shown in Fig. 7, in some optional embodiments, the first circuit 210 and a number *a* of second circuits 220 form a first circuit block 220a, *a* is an integer greater than 1, at least the part of the first connection line 310 extending along the first direction X is located at a side of the first circuit block 200a along the second direction Y where the first circuit 210 connected with the first connection line 310 is located. In Fig. 7, the first circuit block 200a is shown in a dashed box, the first circuit 210 and the second circuits 220 located in the same dashed box belong to the same first circuit block 200a, but the structure of the display panel 100 of the present application is not limited by the dashed box.

In these optional embodiments, the first connection line 310 is located at a side of the first circuit block 200a along the second direction Y where the first circuit 210 connected with the first connection line 310 is located, so that the first connection line 310 is located in the reserved space of the first circuit block 200a, and at least a part of the first connection line 310 does not overlap the first circuit block 200a. Accordingly, the parasitic capacitance between the first connection line 310 and the first circuit block 200a, which affects the signal transmission, can be avoided.

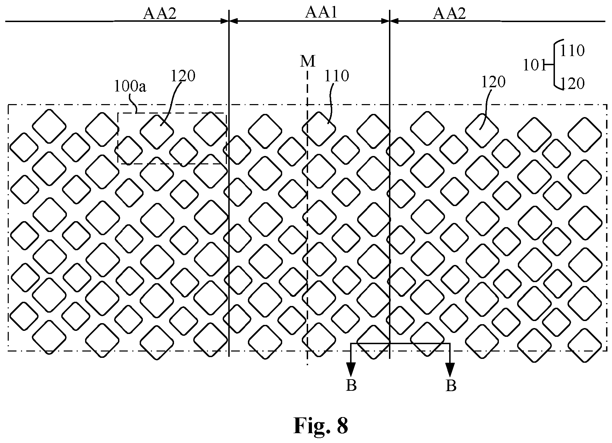

Still referring to Fig. 7 and Fig. 8, in some optional embodiments, a number *a* of adjacent second sub-pixels 120 form a pixel block 100a, the *a* second circuits 220 in the first circuit block 200a are configured to drive the *a* second sub-pixels 120 in a same pixel block 100a, the display panel 100 includes a plurality of first circuit blocks 200a, and a relative position between each first circuit block 200a and the pixel block 100a driven by the first circuit block 200a is the same.

The pixel block 100a driven by the first circuit block 200a is the pixel block 100a where the *a* adjacent second sub-pixels 120 driven by the *a* second circuits 220 in the first circuit block 200a are located.

The pixel block 100a is shown in a dashed box in Fig. 8, and a second sub-pixel 120 with an area within the dashed box greater than 50% of the area of the second sub-pixel 120 is the second sub-pixel 120 included in the pixel block 100a denoted by the dashed box. The structure of the display panel according to the embodiments of the present application is not limited by the dashed box.

The relative position between each first circuit block 200a and the pixel block 100a driven by the first circuit block 200a being the same means that: for example, the display panel 100 includes a plurality of first circuit blocks 200a, each first circuit block 200a is staggered with the pixel block 100a driven by the first circuit block 200a along a thickness direction, and each first circuit blocks 200a is staggered with the pixel block 100a driven by the first circuit block 200a by the same size and along the same direction.

In these optional embodiments, the relative position between each first circuit block 200a and the pixel block 100a driven by the first circuit block 200a is the same, on the one hand, the distance between the second circuit 220 in the first circuit block 200a and the second sub-pixel 120 driven by the second circuit 220 can be reduced, the length of the wiring between the second circuit 220 and the second sub-pixel 120 driven by the second circuit 220 can be reduced, and the signal transmission stability can be improved; on the other hand, the effect of arranging the first circuit 210 in the first circuit block 200a on the second circuit 220 can be reduced.

Optionally, a relative position between each second circuit 220 and the second sub-pixel 120 driven by the second circuit 220 is the same, so that the lengths of the wirings for connecting the second circuits 220 with the second sub-pixels 120 are the same. Accordingly, in the second display area AA2, the signal transmission rates of multiple groups of the second circuit 220 and the second sub-pixel 120 tend to be the same, so that the display uniformity of the second display area AA2 can be further improved.

In addition, the relative position between each second circuit 220 and the second sub-pixel 120 driven by the second circuit 220 is the same, so that the interaction between each second circuit 220 and the second sub-pixel 120 driven by the second circuit 220 also tends to be the same, the environments where a plurality of second sub-pixels 120 are located tend to be the same, and therefore the display uniformity of the second display area AA2 can be further improved.

If the first circuit 210 is arranged in the first circuit block 200a, the relative position between each first circuit block 200a and the pixel block 100a driven by the first circuit block 200a may be the same by reducing the sizes of the first circuit 210 and the second circuit 220.

The pixel driving circuit 102 may be arranged in various ways. In some optional embodiments, still referring to Fig. 7, the pixel driving circuit 102 further includes a virtual area 230, and the virtual area 230 and a number *a* of second circuits 220 form a second circuit block 200b.

In these embodiments, the virtual area 230 is arranged so that the arrangement of the second circuit block 200b and the arrangement of the first circuit block 200a can be the same, so as to reduce the display difference and further improve the display uniformity of the second display area AA2.

In some optional embodiments, still referring to Fig. 7, virtual conductive lines 104 are arranged at a side of at least a part of the second circuit blocks 200b along the second direction Y, and the virtual conductive lines 104 extend along the first direction X. The virtual lines are shown as dashed lines in Fig. 7.

In these optional embodiments, the virtual conductive lines 104 are arranged so that the non-uniform display in the second display area AA2 caused by arranging the first connection lines 310 can be reduced. The virtual conductive line 104 is located at a side of the second circuit block 200b along the second direction Y, so that the overlapping between the virtual conductive line 104 and the second circuit block 200b can be avoided.

The virtual conductive line 104 may be arranged in various ways, and the second circuit blocks 200b are different positions may be arranged correspond to different virtual conductive lines 104.

In some embodiments, a plurality of second circuit blocks 200b include the second circuit block 200b located at a side of the first circuit block 200a along the second direction Y (for example, the second circuit block 200b located below the first circuit block 200a in Fig. 7), the virtual conductive line 104 includes a first virtual conductive line 410 located at a side of the first connection line 310 along the second direction Y (for example, the first virtual conductive line 410 is located below the first connection line 310 in Fig. 7), that is, the first virtual conductive line 410 is located at at least one side of the first circuit block 200a along the second direction Y, and a relative position between the second circuit block 200b and the first virtual conductive line 410 corresponding to the second circuit block 200b is the same as a relative position between the first circuit block 200a and the first connection line corresponding to the first circuit block 200a.

The first virtual conductive line 410 corresponding to the second circuit block 200b is the first virtual conductive line 410 located at a side of the second circuit block 200b along the second direction Y. The first connection line 310 corresponding to the first circuit block 200a is the first connection line 310 with which the first circuit 210 within the first circuit block 200a is connected, and the first connection line 310 is located at a side of the first circuit block 200a along the second direction Y.

In these optional embodiments, the first virtual conductive line 410 is arranged at a side of the second circuit block 200b along the second direction Y, so that the wiring density uniformity along the second direction Y can be improved, thereby improving the display uniformity of the second display area AA2 along the second direction Y. The relative position between the second circuit block 200b and the first virtual conductive line 410 corresponding to the second circuit block 200b is the same as the relative position between the first circuit block 200a and the first connection line 310 corresponding to the first circuit block 200a, and for example, as shown in Fig. 7, if the first connection line 310 is located below the first circuit block 200a corresponding to the first connection line 310, the first virtual conductive line 410 corresponding to the second circuit block 200b is also located below the second circuit block 200b, so that the non-uniform wiring density caused by the existence of both of the first virtual conductive line 410 and the first connection line 310 between the second circuit block 200b and the first circuit block 200a can be avoided.

Optionally, a plurality of rows of the second circuit blocks 200b are arranged at at least one side of the first circuit block 200a along the second direction Y, and the first connection line 410 is arranged at a same side of each row of the second circuit blocks 200b along the second direction Y. The row direction is the first direction X, and the plurality of rows of the second circuit blocks 200b are arranged along the second direction Y.

In these optional embodiments, the first virtual conductive line 410 is arranged at a side of each row of the second circuit blocks 200b, so that the wiring density uniformity along the second direction Y can be further improved, thereby improving the display uniformity of the second display area AA2.

Optionally, the virtual conductive lines 104 include second virtual conductive lines 420 located at at least one side of the first connection lines 310 along the first direction X, so that wiring density uniformity in the second display area AA2 along the first direction X can be improved, thereby improving the display uniformity of the second display area AA2.

Optionally, the *a* second circuits 220 in the second circuit block 200b are configured to drive the *a* second sub-pixels 120 in the same pixel block 100a, and the relative position between each second circuit block 200b and the pixel block 100a driven by the second circuit block 200b is the same, so as to reduce the effect of arranging the virtual area 230 in the second circuit block 200b on the connection between the second circuit 220 and the second sub-pixel 120, reduce the distance between the second circuit block 200b and the pixel block 100a driven by the second circuit block 200b, that is, reduce the distance between the second circuit 210 in the second circuit block 200b and the second sub-pixel 120 driven by the second circuit 220, and reduce the length of the wirings, thereby improving the signal transmission stability.

Optionally, along the thickness direction Z of the display panel, a size of an orthographic projection of the first circuit 210 is the same as a size of the virtual area 230, so that the display uniformity of the second display area AA2 can be further improved.

Optionally, the first signal line 510 of the display panel 100 includes a first conductive line extending along the first direction X and a second conductive line extending along the second direction Y. The first conductive line is, for example, a scanning line, a light emission control signal line, a voltage reference line, and the like. The second conductive line is, for example, a data signal line, a power line, and the like.

Assuming that two first circuits 210 are arranged adjacently along the second direction Y, in the two first circuits 210 arranged adjacently along the second direction Y, a distance between a first conductive line connected with the upper first circuit 210 and a first conductive line connected with the lower first circuit 210 may be a size L of the first circuit 210 along the second direction Y. For example, a distance between the center, along the second direction Y, of the first conductive line connected with the upper first circuit 210 and the center, along the second direction Y, of the first conductive line connected with the lower first circuit 210 may be the size L of the first circuit 210 along the second direction Y.

Assuming that two first circuits 210 are arranged adjacently along the first direction X, in the two first circuits 210 arranged adjacently along the first direction X, a distance between a second conductive line connected with the previous first circuit 210 and a second conductive line connected with the later first circuit 210 may be a size H of the first circuit 210 along the first direction X. For example, a distance between the center, along the first direction X, of the second conductive line connected with the previous first circuit 210 and the center, along the first direction X, of the second conductive line connected with the later first circuit 210 may be the size H of the first circuit 210 along the first direction X.

If the first circuit 210 and the second circuit 220 are arranged adjacently along the second direction Y, and the first circuit 210 is located between the first conductive line connected with the first circuit 210 and the first conductive line connected with the second circuit 220, then in the first circuit 210 and the second circuit 220 adjacent along the second direction Y, a distance between the center, along the second direction Y, of the first conductive line connected with the first circuit 210 and the center, along the second direction Y, of the first conductive line connected with the second circuit 220 may be the size L of the first circuit 210 along the second direction.

If the first circuit 210 and the second circuit 220 are arranged adjacently along the first direction X, and the first circuit 210 is located between the second conductive line connected with the first circuit 210 and the second conductive line connected with the second circuit 220, then in the first circuit 210 and the second circuit 220 adjacent along the first direction X, a distance between the second conductive line connected with the first circuit 210 and the second conductive line connected with the second circuit 220 may be the size H of the first circuit 210 along the first direction X.

Along the thickness direction Z of the display panel, the size of the orthographic projection of the first circuit 210 may be H * L.

Optionally, the number of the first circuits 210 in the first circuit block 200a is the same as the number of the virtual areas 230 in the second circuit block 200b, so that the display effect of the virtual area 230 is the same as the display effect of the area where the first circuit 210 is located, and the display uniformity of the second display area AA2 can be further improved.

Optionally, along the thickness direction Z of the display panel, a size of an orthographic projection of the first circuit block 200a is the same as a size of an orthographic projection of the second circuit block 200b, so the size of the *a* second circuits 220 in the first circuit block 200a and the size of the *a* second circuits 220 in the second circuit block 200b are the same, so that the display uniformity of the second display area AA2 can be further improved.

The size of the orthographic projection of the first circuit block 200a is the sum of the sizes of the orthographic projections of the first circuit 210 and the *a* second circuits 220 in the first circuit block 200a. The size of the orthographic projection of the second circuit block 200b is the sum of the sizes of the orthographic projections of the virtual area 230 and the *a* second circuits 220 in the second circuit block 200b.

If the first circuit 210 and the second circuit 220 are arranged adjacently along the second direction Y, and the second circuit 210 is located between the first conductive line connected with the first circuit 210 and the first conductive line connected with the second circuit 220, then in the first circuit 210 and the second circuit 220 adjacent along the second direction Y, a distance between the center, along the second direction Y, of the first conductive line connected with the first circuit 210 and the center, along the second direction Y, of the first conductive line connected with the second circuit 220 may be a size L' of the second circuit 210 along the second direction Y.

If the first circuit 210 and the second circuit 220 are arranged adjacently along the first direction X, and the second circuit 210 is located between the second conductive line connected with the first circuit 210 and the second conductive line connected with the second circuit 220, then in the first circuit 210 and the second circuit 220 adjacent along the first direction X, a distance between the second conductive line connected with the first circuit 210 and the second conductive line connected with the second circuit 220 may be a size H' of the second circuit 210 along the first direction X.

Along the thickness direction Z of the display panel, the size of the orthographic projection of the second circuit 220 is L' * H'.

Optionally, a relative positional relationship between the first circuit 210 and the second circuits 220 in the first circuit block 200a is the same as a relative positional relationship between the virtual area 230 and the second circuits 220 in the second circuit block 200b, so that the layout and manufacturing of the pixel driving circuit 102 are further simplified, and the display uniformity of the second display area AA2 can be further improved.

Optionally, a virtual circuit is arranged in the virtual area 230, and the structure of the virtual circuit is the same as the structure of the first circuit 210, so that the display effect of the virtual area 230 is the same as the display effect of the area where the first circuit 210 is located, and the display uniformity of the second display area AA2 can be further improved.

Optionally, the second display area AA2 includes a main display area and a transition area located between the main display area and the first display area AA1, the first circuit 210 is located in the transition area, and the virtual area 230 is located in the main display area, so that a distance between the first circuit 210 and the first display area AA1 is relatively small, and the wiring length between the first circuit 210 and the first sub-pixel 110 can be reduced.

In some optional embodiments, the connection lines 103 connected with the sub-pixels 101 of a same color are manufactured using a same material.

In these optional embodiments, the connection lines 103 made of a same material are used for the sub-pixels 101 of a same color, so that the pixel brightness difference caused by the resistance difference of the connection lines 103 can be reduced, and the display uniformity of the second display area AA2 can be further improved.

In some optional embodiments, the first sub-pixels 110 and the second sub-pixels 120 are distributed in rows and columns along the first direction X and the second direction Y, the first circuits 210 and the second circuits 220 are distributed in rows and columns along the first direction X and the second direction Y, at least a part of the first circuits 210 and the second circuits 220 are arranged side by side along the first direction X and located in a same row, and the first circuits 210 and the second circuits 220 located in a same row are configured to drive the first sub-pixels 110 and the second sub-pixels 120 located in a same row.

In these optional embodiments, the first circuits 210 are connected with the first sub-pixels 110 through the first connection lines 310, and the second circuits 220 are connected with the second sub-pixels 120 through the second connection lines 320. If the first circuits 210 and the second circuits 220 in a same row are arranged in the same row as the first sub-pixels 110 and the second sub-pixels 120 driven by the first circuits 210 and the second circuits 220, the shape of the scanning line can be simplified, thereby facilitating the scanning line to drive the first sub-pixels and the second sub-pixels in a same row, and improving the signal transmission stability.

In some optional embodiments, the first display area AA1 is arranged symmetrically with respect to a first symmetry axis M that extends along the second direction Y and passes through the center of the first display area AA1, a plurality of first circuits 210 are distributed symmetrically with respect to the first symmetry axis M, and the first circuit 210 and the first sub-pixel 110 driven by the first circuit 210 are located at a same side of the first symmetry axis M, so as to further reduce the distance between the first circuit 210 and the first sub-pixel 110 driven by the first circuit 210, and reduce the wiring distance.

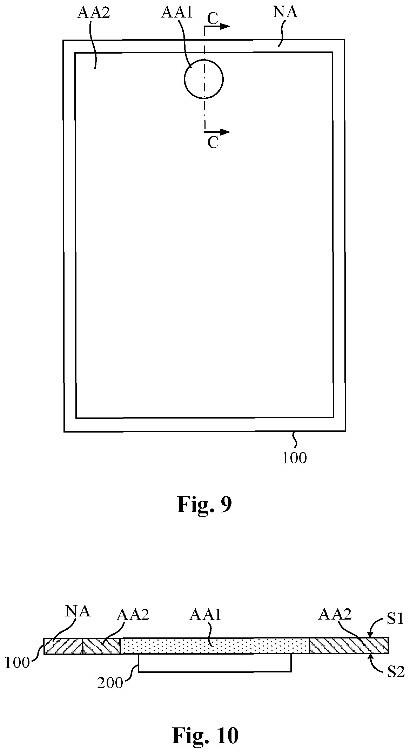

Reference is made to Fig. 9 and Fig. 10, in which Fig. 9 shows a schematic structural diagram of a display apparatus according to the embodiments of the present application, and Fig. 10 shows a cross-sectional view at D-D in Fig. 9.

The display apparatus according to the embodiments of the second aspect of the present application may include the display panel 100 according to any of the above implementations. In the display apparatus according to the embodiments, the display panel 100 may be the display panel 100 according to one of the above embodiments which includes the first display area AA1 and the second display area AA2.

Optionally, the light transmittance of the first display area AA1 is greater than the light transmittance of the second display area AA2. That is, if the first display area AA1 is the light-transmitting display area, the display apparatus further includes a photosensitive component 200 located in the first display area AA1.

The display panel 100 includes a first surface S1 and a second surface S2 opposite to each other, and the first surface S1 is the display surface. The display apparatus further includes the photosensitive component 200 located at a side of the display panel 100 corresponding to the second surface S2, and the photosensitive component 200 corresponds to the position of the first display area AA1.

In the display apparatus according to the embodiments of the present application, the light transmittance of the first display area AA1 is greater than the light transmittance of the second display area AA2, so that the photosensitive component 200 can be integrated at the back of the first display area AA1 of the display panel 100 to achieve under-screen integration for the photosensitive component 200 such as an image capturing component, while the first display area AA1 can display images, the display area of the display panel 100 is increased, and a full-screen design is achieved for the display apparatus.

The photosensitive component 200 may be an image capturing component for capturing external image information. In the embodiments, the photosensitive component 200 is a complementary metal oxide semiconductor (CMOS) image capturing component. In some other embodiments, the photosensitive component 200 may be other image capturing component such as a charge-coupled device (CCD) image capturing component. It should be understood that the photosensitive component 200 may not be limited to an image capturing component, and for example, in some embodiments, the photosensitive component 200 may be a light sensor such as an infrared sensor, a proximity sensor, an infrared lens, a flood sensing element, an ambient light sensor, and a dot matrix projector. In addition, other components may be integrated at the side of the display panel 100 of the display apparatus corresponding to the second surface S2, such as a telephone receiver or a speaker.

In some other embodiments, if the first display area AA1 is arranged around at least a part of the second display area AA2, that is, the first display area AA1 is the frame display area, the driving components such as the shift registers can be arranged in the first display area AA1, so that the size of the frame of the display panel 100 can be reduced, and the narrow frame can be achieved.

In some other embodiments, the first display area AA1 may include both of the light-transmitting display area and the frame display area, so that the under-screen integration of the photosensitive components and the narrow frame can be achieved.

The above embodiments of the present application do not exhaustively describe all the details, nor do they limit the present application to the specific embodiments as described. Obviously, according to the above description, many modifications and changes can be made. These embodiments are selected and particularly described in the specification to better explain the principles and practical applications of the present application, so that a person skilled in the art is able to utilize the present application and make modifications based on the present application. The present application is limited only by the claims and the full scope and equivalents of the claims.

## Claims

1. A display panel comprising a first display area and a second display area, the display panel comprising:
sub-pixels comprising first sub-pixels located in the first display area and second sub-pixels located in the second display area;
pixel driving circuits located in the second display area and comprising first circuits configured to drive the first sub-pixels and second circuits configured to drive the second sub-pixels; and
connection lines comprising first connection lines for connecting the first circuits with the first sub-pixels;
wherein at least a part of the first connection line extends along a first direction and is located at a side of the first circuit.

2. The display panel according to claim 1, wherein the display panel further comprises a first signal line layer comprising a first signal line, at least a part of the first connection line is located in the first signal line layer, and the first signal line comprises at least one of a data line, a scanning line, a power line, a voltage reference line, and a ground line.

3. The display panel according to claim 2, wherein the display panel further comprises a light-transmitting signal line layer, the first connection line comprises a first segment located in the first display area and a second segment located in the second display area, the first segment is located in the light-transmitting signal line layer, and the second segment is located in the first signal line layer and/or the light-transmitting signal line layer.

4. The display panel according to claim 1, wherein the first circuit and a number *a* of second circuits form a first circuit block, *a* is an integer greater than 1, at least the part of the first connection line extending along the first direction is located at a side of the first circuit block where the first circuit connected with the first connection line is located.

5. The display panel according to claim 4, wherein a number *a* of adjacent second sub-pixels form a pixel block, the *a* second circuits in the first circuit block are configured to drive the *a* second sub-pixels in a same pixel block, the display panel comprises a plurality of first circuit blocks, and a relative position between each first circuit block and the pixel block driven by the first circuit block is the same.

6. The display panel according to claim 5, wherein the pixel driving circuit further comprises a virtual area, and the virtual area and a number *a* of second circuits form a second circuit block.

7. The display panel according to claim 6, wherein the *a* second circuits in the second circuit block are configured to drive the *a* second sub-pixels in a same pixel block, the display panel comprises a plurality of second circuit blocks, and a relative position between each second circuit block and the pixel block driven by the second circuit block is the same.

8. The display panel according to claim 6, wherein along a thickness direction of the display panel, a size of an orthographic projection of the first circuit is the same as a size of the virtual area; and a size of an orthographic projection of the first circuit block is the same as a size of an orthographic projection of the second circuit block.

9. The display panel according to claim 6, wherein a number of the first circuits in the first circuit block is the same as a number of the virtual areas in the second circuit block.

10. The display panel according to claim 1, wherein at least the part of the first connection line extending along the first direction is located at a side of the first circuit along a second direction, and the first direction intersects the second direction.

11. The display panel according to claim 6, wherein a relative positional relationship between the first circuit and the second circuits in the first circuit block is the same as a relative positional relationship between the virtual area and the second circuits in the second circuit block.

12. The display panel according to claim 6, wherein a virtual circuit is arranged in the virtual area, and a structure of the virtual circuit is the same as a structure of the first circuit.

13. The display panel according to claim 1, wherein the second display area comprises a main display area and a transition area located between the main display area and the first display area, and the first circuits are located in the transition area.

14. The display panel according to claim 6, wherein virtual conductive lines are arranged at a side of at least a part of the second circuit blocks along a second direction, the virtual conductive lines extend along the first direction, and the first direction intersects the second direction.

15. The display panel according to claim 14, wherein the virtual conductive lines comprise first virtual conductive lines located at at least one side of the second circuit blocks along the second direction, and a relative position between the second circuit block and the first virtual conductive line corresponding to the second circuit block is the same as a relative position between the first circuit block and the first connection line corresponding to the first circuit block.

16. The display panel according to claim 15, wherein a plurality of rows of the second circuit blocks are arranged at at least one side of the first circuit block along the second direction, the first virtual conductive lines are arranged at a same side of the rows of the second circuit blocks along the second direction.

17. The display panel according to claim 14, wherein the virtual conductive lines comprise second virtual conductive lines located at at least one side of the first connection lines along the first direction.

18. The display panel according to claim 1, wherein the connection lines connected with the sub-pixels of a same color are manufactured using a same material.

19. The display panel according to claim 1, wherein the first sub-pixels and the second sub-pixels are distributed in rows and columns, the first circuits and the second circuits are distributed in rows and columns, at least a part of the first circuits and the second circuits are arranged side by side along the first direction and located in a same row, and the first circuits and the second circuits located in a same row are configured to drive the first sub-pixels and the second sub-pixels located in a same row.

20. A display apparatus comprising the display panel according to any of claims 1 to 19.
